**Europäisches Patentamt**

**European Patent Office**

**Office européen des brevets**

(19)

(11) Veröffentlichungsnummer: **0 292 519 B1**

(12) **EUROPÄISCHE PATENTSCHRIFT**

(45) Veröffentlichungstag der Patentschrift:
07.08.91 Patentblatt 91/32

(51) Int. Cl.⁵: **H01J 37/317, G03F 7/20**

(21) Anmeldenummer: 87907732.9

(22) Anmeldetag: 07.12.87

(86) Internationale Anmeldenummer:
PCT/CH87/00166

(87) Internationale Veröffentlichungsnummer:
WO 88/04470 16.06.88 Gazette 88/13

(54) **VERFAHREN UND VORRICHTUNG ZUR ERZEUGUNG VON MATERIALSTRUKTUREN IM BEREICH ATOMARER DIMENSIONEN.**

(30) Priorität: 07.12.86 CH 4868/86

(43) Veröffentlichungstag der Anmeldung:
30.11.88 Patentblatt 88/48

(45) Bekanntmachung des Hinweises auf die Patenterteilung:
07.08.91 Patentblatt 91/32

(84) Benannte Vertragsstaaten:
AT BE CH DE FR GB IT LI LU NL SE

(56) Entgegenhaltungen:
EP-A- 0 166 119
US-A- 4 550 257
IBM Technical Disclosure Bulletin, Vol.29 Nr. 6 November 1986 (Armonk, New York, US), "Direct pattern writing by local heating in a scanning tunneling microscope", pages 2680-2681
Journal of Vacuum Science and Technology B, Vol. 4, Nr 1 January-February 1986 second series (New York, US) M.A. McCord et al.: "Lithography with the scanning tunneling microscope", pages 86-88
Applied Physics Letters, Vol.46, Nr. 9, May 1985 (Woodbury, New York, US) M.Ringger et al.: "Nanometer lithography with the scanning tunneling microscope", page 832-834
IBM Journal of Research and Development, Vol.30, Nr. 5, September 1986 M. Ringger et al.: "STM activity at the University of Basel",

(73) Patentinhaber: LASARRAY HOLDING AG
CH-8512 Thundorf (CH)

(72) Erfinder: STAUFER, Urs
Poolstrasse 5
CH-4414 Füllinsdorf (CH)
Erfinder: WIESENDANGER, Roland
Eggenweg 5
W-7850 Lörrach (DE)
Erfinder: ENG, Lukas
Klybeckstrasse 75
CH-4057 Basel (CH)
Erfinder: ROSENTHALER, Lukas
Reusstrasse 70
CH-4054 Basel (CH)
Erfinder: HIDBER, Hans, Rudolf
Thiersteinerstrasse 20/3
CH-6153 Reinach (CH)
Erfinder: GRUETTER, Peter
Schlettstadtstrasse 10
CH-4055 Basel (CH)
Erfinder: GUENTHERODT, Hans-Joachim
Weisskirchweg 13
CH-4108 Witterswil (CH)

(74) Vertreter: Frauenknecht, Alois J. et al
c/o PPS Polyvalent Patent Service AG,
Mellingerstrasse 1
CH-5400 Baden (CH)

## Beschreibung

Die Erfindung betrifft ein Verfahren zur Erzeugung von Oberflächenstrukturen auf elektrisch leitenden oder halbleitenden Substratoberflächen im Bereich atomarer Dimensionen mit einem Rastertunnelmikroskop, wobei mittels eines Tunnelstroms das Substrat lokal erwärmt wird und somit thermische Umwandlungen eingeleitet werden. Ferner betrifft die Erfindung eine Vorrichtung zur Durchführung dieses Verfahrens.

Anwendungsgebiete für das Verfahren und die Vorrichtung sind insbesondere die Herstellung, Beeinflussung oder Änderung von Oberflächenstrukturen auf elektrisch leitenden oder halbleitenden Materialoberflächen im atomaren Bereich, also in der Grössenordnung einiger Nanometer. Strukturen können Oberflächenerhöhungen, -vertiefungen oder lokal begrenzte unterschiedliche Eigenschaften anderer Art sein, z.B. amorph/kristallin, magnetisch/unmagnetisch, supraleitend/nicht supraleitend.

Zur kommerziellen Herstellung von Strukturen auf einem Substrat, z.B. von Leiterbahnen bei der Halbleiterherstellung, liegen die Grössenordnungen der Strukturbreiten im Bereich von einigen Mikrometern. Die Herstellung solcher Strukturen erfolgt mit dem Elektronenstrahl eines Elektronenmikroskops entweder mit der Maskentechnik oder im Direktschreibeverfahren. Aus verschiedenen Gründen werden Bemühungen unternommen, die Grössenordnungen solcher Strukturen zu verkleinern und entsprechende Herstellungsverfahren bereitzustellen.

Im Zusammenhang mit dem Rastertunnelmikroskop (Scanning Tunneling Microscope) ist eine rasterförmige Abtastung von Oberflächen im Nanometer-Bereich zur Bestimmung der Oberflächentopographie von Probenoberflächen bekannt (Helv. Phys. Acta, Vol 55, 1982, S. 726-735). Ferner sind aus EP-A-0'166'308 und EP-A-0'166'119 Verfahren bzw. Vorrichtungen bekannt zum gezielten Aufbringen von Materialstrukturen unter hohen elektrischen Feldern bei einer Distanz von einigen 10 nm zwischen Abtastspitze und Substratoberfläche. Es sollen dabei Materialstrukturen im Nanometerbereich realisierbar sein. Dabei soll das aufzubringende Material entweder aus der Gasphase gewonnen werden, oder das Aufbringen soll durch Felddesorption erfolgen. Beide Alternativen sind nur begrenzt einsetzbar, da sie bezüglich der technischen Anwendungsmöglichkeit zu wenig flexibel sind.

Aus IBM Technical Disclosure Bulletin, Band 29, Nr. 6, November 1986, Seiten 2680-2681, ist ein Verfahren bekannt, das auf einem Substrat eine gewünschte Struktur schreiben lässt. Dazu wird das Substrat, ein Siliziumsubstrat mit einer aufgedampften Metallschicht, lokal durch ein Rastertunnelmikroskop in einem Bereich mit einem Durchmesser von Zirka $10^{-8}$m (100 Å) aufgewärmt, wodurch das Metall in neue Silicide-Verbindungen umgewandelt wird. Die nicht umgewandelten Gebiete werden dann durch selektives, chemisches Aetzen entfernt. Dieses Verfahren ermöglicht das Aufbringen von Leiterbahnen auf einem Siliziumsubstrat ohne die Verwendung eines Resist-Materials.

Aus IBM Journal of Research and Development, Band 30, Nr. 5, September 1986, Seiten 500-507, ist ferner eine Tunnel-Einheit eines Rastertunnelmikroskops mit einer zweidimensional arbeitenden, magnetischen Bewegungsvorrichtung für das Substrat und einem piezoelektrischen Antrieb für die Tunnelspitze bekannt.

Der vorliegenden Erfindung liegt die Aufgabe zugrunde, ein Verfahren gemäss dem Oberbegriff des Patentanspruchs 1 und eine Vorrichtung zur Durchführung des Verfahrens anzugeben, mit welchen sich in direkter Weise und auf einfache, zuverlässige und praxisgerechte Art Strukturen im Nanometerbereich auf leitenden oder halbleitenden Substraten herstellen lassen.

Diese Aufgabe wird erfindungsgemäss durch die in den Patentansprüchen 1 und 9 definierten Merkmale gelöst.

Die dort definierten Massnahmen erlauben die Herstellung von Strukturen unter Einsatz eines Rastertunnelmikroskops durch thermisch eingeleitete Phasenumwandlungen im Bereich von Nanometern, erzeugt durch eine hohe lokale Stromdichte von Tunnelelektronen im Elektronenvoltbereich. Für die Entstehung der Strukturen kann die hohe elektrischen Feldstärke von Bedeutung sein. Die hohe Leistung, welche in ein kleines Volumen nahe der Substratoberfläche gesteckt wird, hat eine lokale Temperaturerhöhung zur Folge. Diese kann allgemein eine Phasenumwandlung in Bereichen von nm einleiten, z.B. kristallin/amorph, magnetisch/unmagnetisch, supraleitend/ nicht supraleitend. Die zusätzlich zur lokalen Temperaturerhöhung vorhandene hohe lokale elektrische Feldstärke kann zur topographischen Beeinflussung der Oberfläche an den aufgeschmolzenen Stellen benutzt werden, so dass sich eine Erscheinung ähnlich dem Taylorkegel bildet, wie er von einer Flüssigmetall-Ionenquelle bekannt ist. Nach Erstarren des behandelten Materials bleibt die topographische Modifikation als Nanometerstruktur bestehen.

Geeignete Substrate sind beispielsweise ionengeätzte metallische Gläser, da sie nach dem Ätzen für die Weiterbehandlung besonders geeignete atomar flache Oberflächen aufweisen. Bevorzugte, für diese Verwendung geeignete Materialien sind unter anderem metallische oder metalloxidische Bänder oder Folien, welche durch rasche Abschreckung direkt aus der Schmelze hergestellt wurden ("Rapidly Quenched Metals").

Mit dem beschriebenen Verfahren lassen sich neben topographischen Modifikationen in kleinen Dimensionen auch Nanometerstrukturen herstellen, deren physikalische Eigenschaften sich von dem sie umgebenden Substrat unterscheiden. Beispielsweise lassen sich ferromagnetische Nanometerstrukturen erzeugen, für welche sich amorphes Material als Substrat besonders gut eignet. Die erzeugten kristallinen Nanometerstrukturen mit den geänderten magnetischen Eigenschaften lassen sich mit magnetischen Sensaren, z.B. in einem magnetischen Kraftmikroskop, nachweisen.

Im folgenden werden Einzelheiten und Ausführungsbeispiele der Erfindung mit Hilfe der Zeichnungen näher erläutet. Es zeigen :

Fig. 1   die schematische Darstellung einer Tunnelspitze über einem Substrat, mit verschiedenen Positionen 1-4,

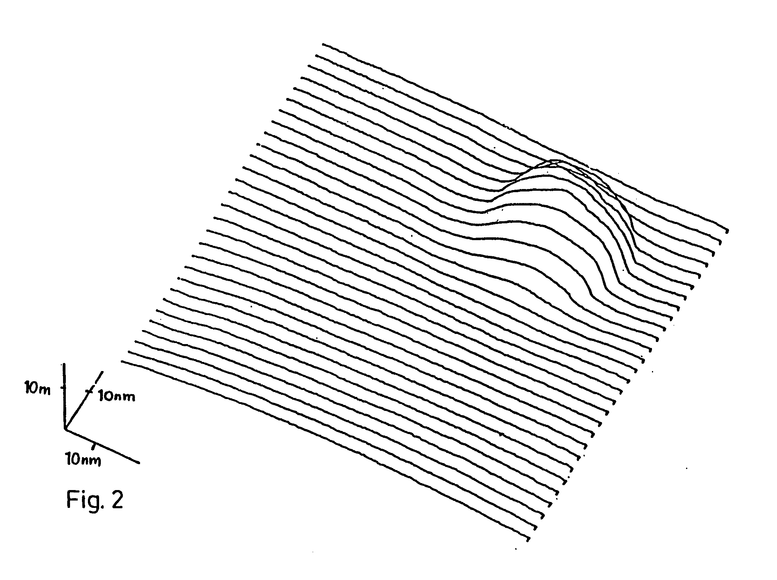

Fig. 2   das Schreiberbild der Substratoberfläche gemäss Fig. 1, nach Erzeugung einer Struktur an der Position 1,

Fig. 3   das Schreiberbild der Substratoberfläche nach Erzeugung einer zusätzlichen Struktur an der Position 2,

Fig. 4   das Schreiberbild der Substratoberfläche nach Erzeugung einer weiteren Struktur an der Position 3,

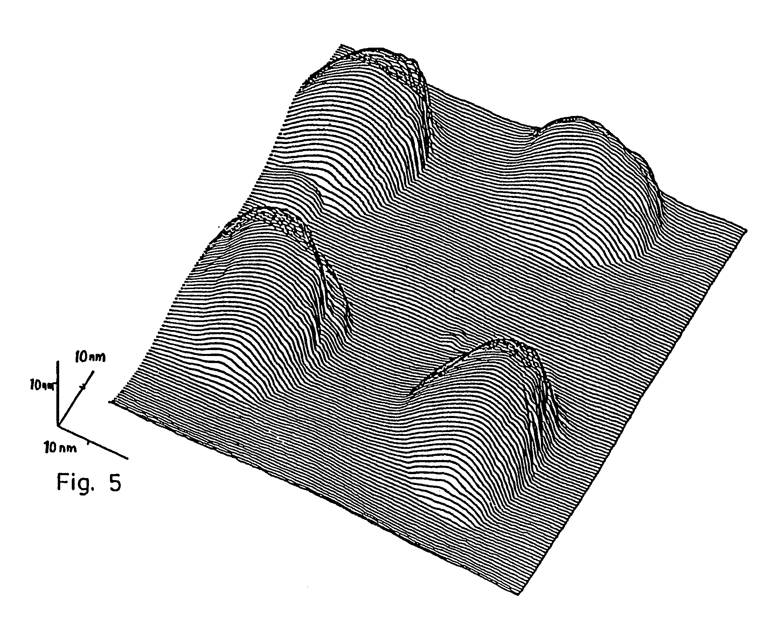

Fig. 5   das Schreiberbild der Substratoberfläche nach Erzeugung einer vierten Struktur an der Position 4,

Fig. 6   den Weg der Tunnelspitze bei der Herstellung einer Linienstruktur,

Fig. 7   das Schreiberbild der Substratoberfläche nach Erzeugung einer Linienstruktur,

Fig. 8   eine Vorrichtung zur Positionierung der wegklappbaren Tunnelspitze, mit Einrichtungen zur Steuerung der Vorrichtung und zur Erfassung der Messwerte, und

Fig. 9   die perspektivische Ansicht der Vorrichtung nach Fig. 8.

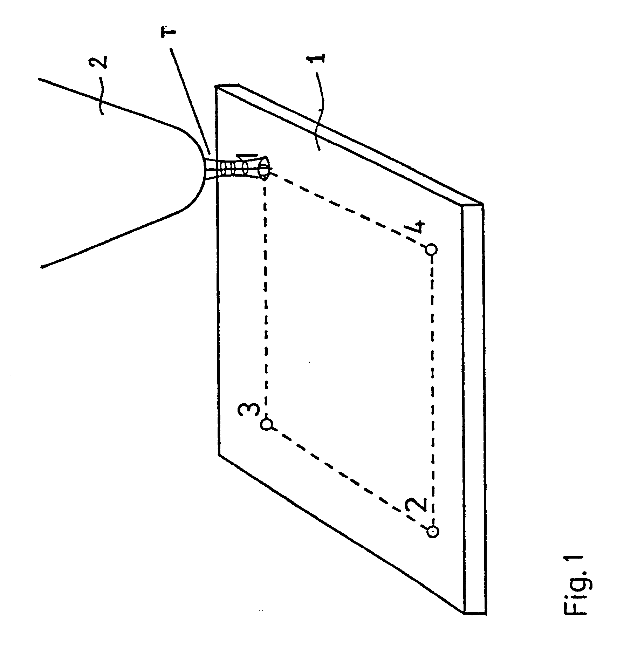

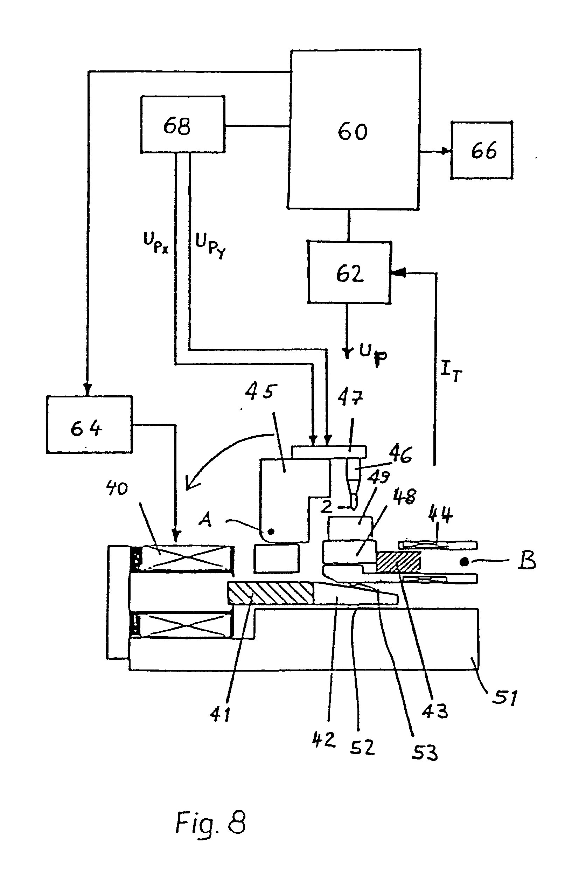

Als ein wesentliches Hilfsmittel für die Herstellung der erwähnten Material-Strukturen im atomaren Bereich dienen Elemente eines an sich bekannten Rastertunnelmikroskops. Wie aus der schematischen Darstellung der Fig. 1 zu erkennen ist, wird ein Substrat 1 unter der Tunnelspitze 2 eines Rastertunnelmikroskops (RTM) positioniert. Die Anordnung befindet sich beispielsweise in einem Ultrahochvakuum (UHV). Das Substrat 1 und die Tunnelspitze 2 sind mit Positionier- und Messeinrichtung verbunden, wie sie in Zusammenhang mit Fig. 8 dargestellt sind. Auf die Funktion des Rastertunnelmikroskops wird hier nicht im einzelnen eingegangen, da sie an sich bekannt ist.

Das Verfahren zur Erzeugung von Strukturen auf der Substratoberfläche setzt, wie erwähnt, möglichst homogene Eigenschaften des Substrats voraus, damit sich die erzeugten Strukturen im Nanometerbereich an dem umgebenden Bereich des Substrats erkennbar abheben. Als Beispiel für eine Substratpräparation bei der Erzeugung topographischer Modifikationen wird das sogenannte Ionenätzen angewendet, in dessen Verlauf Ar-Ionen mit einer Energie von 5 keV während 35 min bei einem Emissionsstrom von 10 mA und einem Druck von 10E-8 mbar im Rezipienten auf die Oberfläche des Substrats geschossen werden. Als Substrat wurde für die hier erwähnten Messwerte Rh25Zr75 gewählt. Die sich durch die Behandlung einstellende Oberflächenrauhigkeit wird anschliessend vom RTM gemessen. Aus den oben erwähnten Gründen muss sie kleiner sein als die kleinsten Abmessungen der zu erzeugenden Nanometerstrukturen. Als Beispiel wurde eine RMS-Rauhigkeit nach dem Ionenätzen gemessen, welche kleiner war als 0,1 nm.

Dem Präparationsverfahren schliesst sich das eigentliche Herstellungsverfahren zur Erzeugung der gewünschten Strukturen auf der Substratoberfläche an. Dazu wird die Tunnelspitze 2, beispielsweise eine Wolfram-Spitze, im normalen Tunnelbetrieb an den Ort über dem Substrat gefahren, an welchem die Struktur entstehen soll. In Fig. 1 ist dies mit Position 1 angedeutet. Ist die gewünschte Position erreicht, was durch Ausmessen und Vergleich mit Hilfe des RTM und der angeschlossenen rechnergestützten Steuergeräte erfolgt, wird die zwischen dem Substrat 1 und der Tunnelspitze 2 anliegende Tunnelspannung vom Millivoltbereich in den Voltbereich erhöht. Gleichzeitig wird bei konstant gehaltenem Tunnelstrom $I_T$ der Abstand zwischen dem Substrat 1 und der Tunnelspitze 2 vergrössert.

Anschliessend wird die Tunnelspitze 2 bei konstant gehaltener Tunnelspannung $U_T$ so weit dem Substrat 1 angenähert, dass ein bestimmter Tunnelstrom, im Beispiel 315 nA, fliesst. Typische Tunnelgap-Widerstände während der Her- stellung der Strukturen liegen bei $10^7$ bis $10^8$ Ohm. Als Ergebnis dieser Behandlung entsteht eine im Beispiel etwa halbkugelförmige Struktur von 35 nm Durchmesser und 10 nm Erhöhung. Diese Masse lassen sich mit dem RTM aus anschliessend aufgenommenen topographischen Bildern entnehmen.

Nach Erfassung und Abspeicherung der Messwerte lassen sich diese auf verschiedene Weise, z.B. als topographische Aufsicht darstellen.

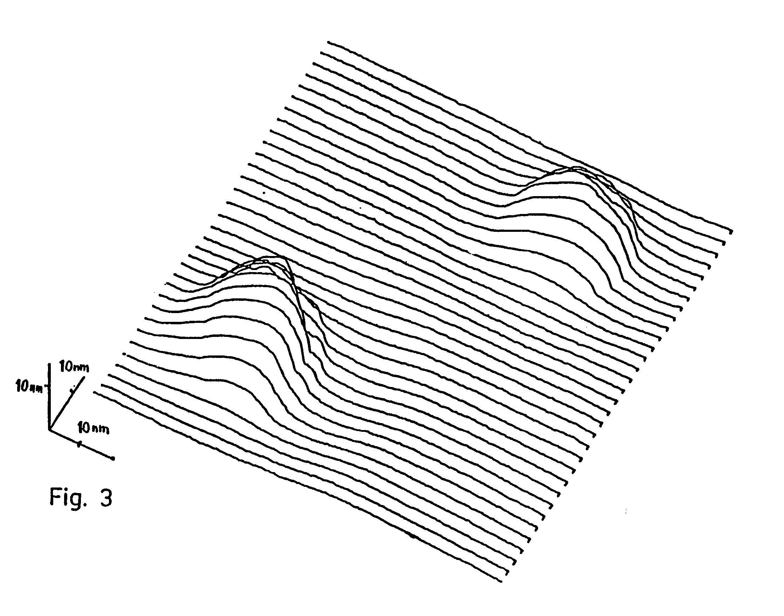

Nach einer gesteuerten Lateralverschiebung der Tunnelspitze 2 von der Position 1 auf die Position 2 gemäss Fig. 1 wird dort eine weitere Struktur erzeugt, wie dies aus Fig. 3 in einer Gesamtdarstellung der beiden Strukturen ersichtlich ist. Die mittlere Distanz zwischen den beiden Positionen 1 und 2 beträgt im Beispiel 85 nm. Die Herstellung der zweiten Struktur an der Position 2 erfolgt nach der gleichen Methode, wie für die erste Struktur an Position 1 beschrieben wurde.

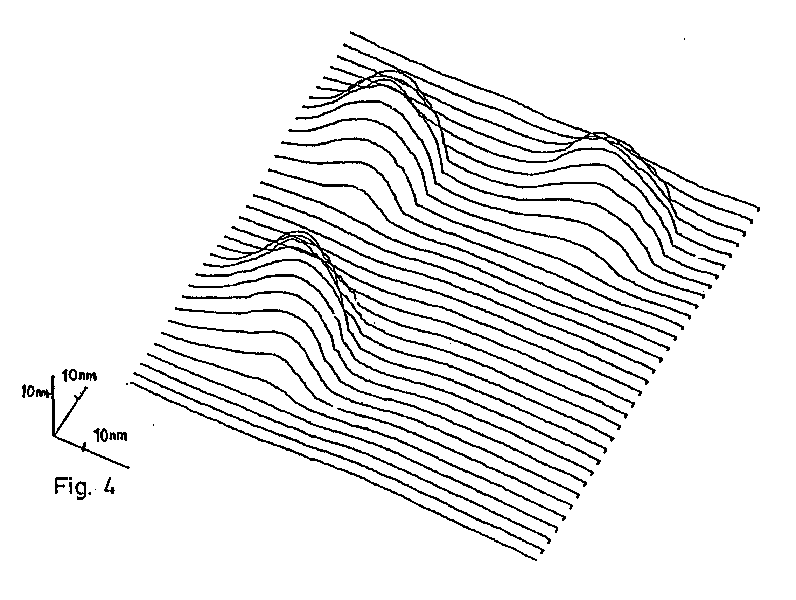

Auf die gleiche Weise lässt sich auch eine dritte Struktur an der Position 3 gemäss Fig. 1 erzeugen, wie aus Fig. 4 ersichtlich ist. In Weiterführung dieses Verfahrens lassen sich beliebig viele Einzelstrukturen auf der Oberfläche des Substrats erzeugen, wobei die Grösse eines entsprechenden Strukturfeldes nur durch die Positioniermöglichkeiten des Rastertunnelmikroskops begrenzt ist.

Basierend auf dem geschilderten grundsätzlichen Verfahren lassen sich die folgenden 4 Verfahrensvarianten durchführen :

1. Das Substrat wird an den ausgewählten Positionen geschmolzen und anschliessend sehr rasch wieder abgekühlt, so dass sich eine amorphe Struktur bildet oder erhält.

2. Das Substrat wird geschmolzen und langsam abgekühlt, so dass sich eine kristalline Struktur bildet oder eine solche erhalten bleibt.

3. Unter dem Einfluss elektrostatischer Effekte lässt sich das Substrat im geschmolzenen Zustand an den ausgewählten Positionen zur Tunnelspitze anziehen.

4. Werden als Substrat Legierungen gewählt, kann mindestens eine Legierungskomponente im geschmolzenen Zustand an den ausgewählten Positionen zum Segregieren oder Migrieren an die Oberfläche veranlasst werden.

Insbesondere in Zusammenhang mit der Durchführung des Verfahrens gemäss der Alternative 3 lassen sich vorhandene Strukturen auf der Substratoberfläche auch überschreiben.

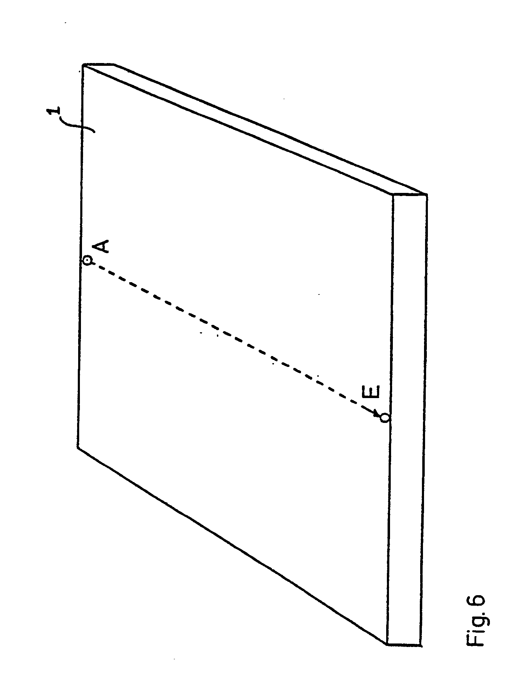

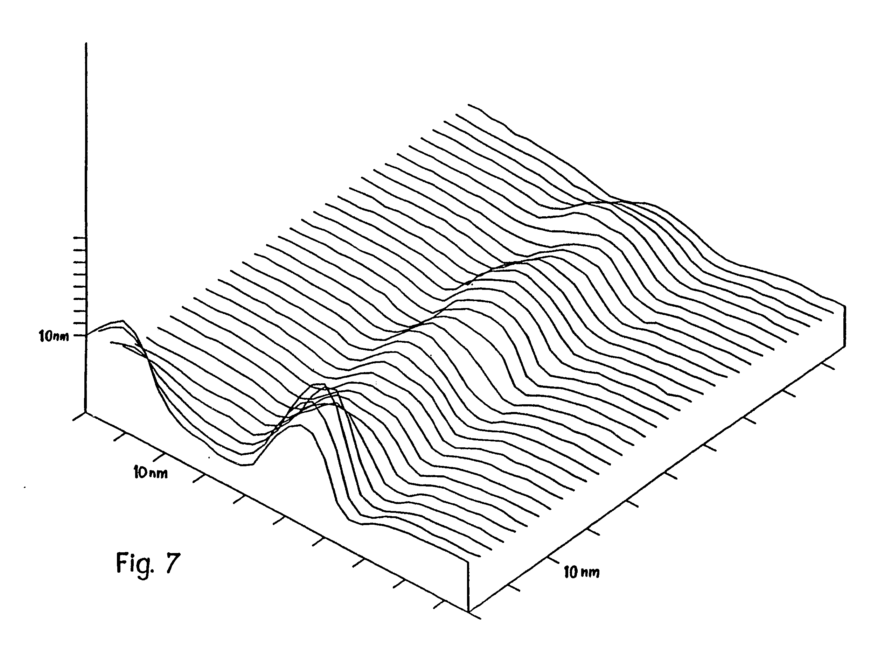

Ferner können ausser den erwähnten halbkugelförmigen Strukturen auch linienförmige Strukturen erzeugt werden, wie dies für ein Beispiel anhand von Fig. 6 und 7 gezeigt ist. In Fig. 6 bedeutet A die Ausgangsposition der Tunnelspitze, von der aus eine Linie auf der Substratoberfläche geschrieben werden soll. Während die Tunnelspitze entlang einer vorgegebenen Linie über die Substartoberfläche geführt wird, müssen zur Erzeugung einer Struktur ab der Position A die Spannung und der Tunnelstrom auf die vorerwähnten Werte erhöht werden. Dabei wird die Tunnelspitze mit einer Geschwindigkeit von etwa 3 nm/sec in Pfeilrichtung längs der vorgegebenen Linie bewegt. Auf diese Weise erzeugte Linien haben z.B. eine Länge von 100 nm, eine Breite von 20 nm und eine Höhe von 2 nm.

Alle diese Prozesse hinterlassen Strukturen an der Substratoberfläche oder veranlassen deren Überschreiben. Das Vorhandensein oder Nichtvorhandensein von Strukturen an vorgegebenen Positionen oder längs definierter Bahnen lassen sich ohne weitere Behandlung des Substrats direkt mit demselben RTM nachweisen, mit dem sie erzeugt wurden. Die Verfahren eignen sich z.B. zur Herstellung von Informations-Massenspeichern, insbesondere von ROM's (Read Only Memories), oder von Leiterstrukturen bei der Herstellung hochintegrierter elektrischer Schaltungen.

Anstelle einer einzelnen Tunnelspitze können auch Gruppen solcher Spitzen gleichzeitig verwendet werden, wodurch die Herstellung von Arrays mit separierten Nanometerstrukturen möglich ist.

Wird der Abstand zwischen der Substratoberfläche und der Tunnelspitze im Bereich einiger Angström (0,1 nm) gehalten, und wird als Spitze ein Material gewählt, welches sich leichter aufschmelzen lässt als das Substrat, so lässt sich durch die hohe lokale elektrische Feldstärke Material aus dem verflüssigten Teil der Tunnelspitze auf dem Substrat als Nanometerstruktur deponieren.

Gemäss einem besonderen Ausführungsbeispiel wird ein ferromagnetisches Material für die Tunnelspitze gewählt, so dass sich auf der Substratoberfläche ferromagnetische Nanometerstrukturen ergeben. Solche Strukturen lassen sich durch magnetische Kraftmessung nachweisen.

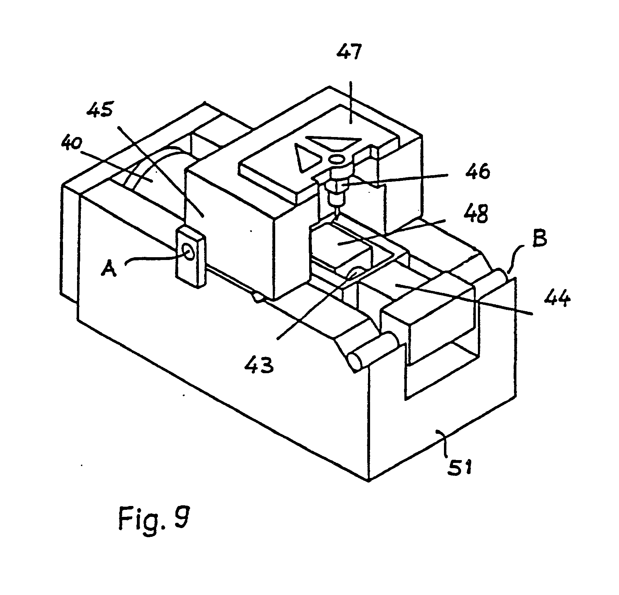

Zur Durchführung des beschriebenen Verfahrens eignet sich z.B. eine Positionier- und Rastervorrichtung, wie sie anhand der Figuren 8 und 9 im folgenden beschrieben wird.

Danach ist im wesentlichen ein Linearmotor, bestehend aus einer Spule 40 und einem Magnet 41 mit einem Keil 42 vorgesehen, wobei der Keil eine Klappvorrichtung betätigt mit dem darauf befindlichen Substrat oder dem Werkstück 49. Die auf einer horizontalen Achse B gelagerte Klappvorrichtung schwenkt je nach Position des Keils 42 in vertikaler Richtung und lässt sich so durch entsprechende Steuerung der Spule 40 sehr präzis an die Tunnelspitze 2 annähern oder von ihr entfernen. Das Substrat oder das Werkstück 49 liegen auf einem Substrathalter 48, der mit einem weiteren Linearmotor verbunden ist. Er besteht aus einem weiteren Permanentmagneten 43 und einer Spule 44 und dient zur eindimensionalen horizontalen Verschiebung des Substrathalters 48.

Zur Führung des Keils 42 auf der Basis 51 und gegenüber der Klappvorrichtung sind an den Gleitflächen zwischen diesen Teilen Kugeln 52 und 53 vorgesehen. Auf der Oberseite der Klappvorrichtung kann eine weitere Bewegungsvorrichtung angebracht sein, um eine zweidimensionale horizontale Bewegung des Substrathalters 48 relativ zur Tunnelspitze zu erreichen. Die Tunnelspitze 2 ist über einen Piezostab 46 an einem um eine Achse A umklappbaren Rasterkopf 45 befestigt. Die Klappvorrichtung erlaubt ein einfaches Manipulieren am Substrathalter nach Wegklappen des Rasterkopfes 45.

4

Die Permanentmagnete 41 und 43 sind im Beispiel aus Cobalt-Samarium gefertigt. Der Keile 42 besteht im Beispiel aus Glaskeramik (z.B. "MACOR"). Als Antriebsimpulse für die Spule wurden z.B. Spannungsimpulse von 15 Volt und einer Pulsbreite von 150 µs verwendet. Die typische Pulsfolgefrequenz lag zwischen 50 und 500 Hz.

Mit Hilfe der beschriebenen Bewegungsvorrichtung lässt sich die Tunnelspitze 2 gemäss Fig. 1 reproduzierbar bis auf den Nanometerbereich an die Substratoberfläche 1 annähern.

Die Bearbeitung grösserer Flächenelemente erfolgt durch Vorpositionieren des Substrats im µm-Bereich mit Hilfe der magnetischen Antriebe 43, 44 und anschliessende Fein-Positionierung im nm-Bereich mittels piezoelektrischer Elemente. Der Substrathalter 48 wird durch den magnetischen Antrieb 40 im µm-Bereich relativ zur Tunnelspitze 2 eingestellt. Die Feinpositionierung im nm-Bereich erfolgt durch das Piezoelement 46, gemäss den Betriebskriterien für ein Tunnelmikroskop fein nachgestellt.

Fig. 9 zeigt eine perspektivische Ansicht der beschriebenen Bauteile. Es ist die um die Achse B horizontal gelagerte Klappvorrichtung für den Substrathalter 48 zu erkennen. Der Keil ist verdeckt. Nur die Spule 40 ist zu sehen. Dargestellt wurde auch die Einrichtung für die eindimensionale horizontale Bewegung des Substrathalters 48, bestehend aus der Spule 44 und dem Permanentmagneten 43. Weiter sind der um die Achse A wegklappbare Rasterkopf mit x-y-Rastereinrichtung 47 zu erkennen, sowie der z-Piezostab 46, an dem die Tunnelspitze 2 befestigt ist.

Der gesamte Abtast-, Mess- und Regelvorgang der bisher beschriebenen Vorrichtung wird durch die im folgenden dargestellten Elemente unterstützt, die um einen zentralen Rechner 60 gruppiert sind und mit diesem zusammenwirken.

Die das Tunnelmikroskop betreffende Regelung erfolgt in einem Regelsystem 62, welches den Tunnelstrom $I_T$ zwischen der Tunnelspitze 2 und dem Substrat 1 laufend misst und ihn durch Nachregeln der Position der Tunnelspitze 2 über die Piezospannung $U_p$ für das Piezoelement 46 konstant hält. Dieses Nachführsignal wird auch als Messsignal M verwendet. Es enthält die Information über die Höhe der Abtastspitze über der Materialoberfläche. Das Signal M wird dem Rechner 60 zugeführt und dort mit den Koordinatenwerten für den Verlauf der Rasterbewegung zwischen der Tunnelspitze 2 und der Oberfläche des Substrats 1 in Beziehung gebracht, so dass sich eine vollständige Darstellung des Höhenprofils auf dem Substrat 1 ergibt.

Zur Ableitung entsprechender koordinatenbezogener Piezospannungen

$$U_{p_x} \quad \text{und} \quad U_{p_y}$$

für die Steuerung der piezoelektrischen Positioniereinrichtung 47 zur rasterförmigen Abtastung des Substrats 1 in X- und Y-Richtung dient eine Piezo-Steuerung 68. Die als Stellsignale ausgelegten Piezospannungen werden aus entsprechenden Steuersignalen abgeleitet, welche vom Rechner 60 geliefert werden.

Zur Steuerung der weiter oben erwähnten Grobpositionierung des Substrats 1 bezüglich seiner Höhendistanz zur Tunnelspitze 2 mit Hilfe des elektromagnetischen Linearantriebs ist eine Antriebssteuerung 64 vorgesehen, welche aus den vom Rechner 60 erhaltenen Signalen Stellsignale, vorzugsweise Stellimpulse, für die Magnetspule 40 ableitet.

Am Rechner 60 sind Ausgabe-Einrichtungen 66 angeschlossen zur Anzeige, zum Ausdrucken oder zum Abspeichern der erhaltenen Höhendistanzprofile bzw. der Positionen von Strukturen.

Mit der beschriebenen Anordnung konnte eine laterale Auflösung im Bereich von ca. 0,1 bis 100 nm erreicht werden.

## Patentansprüche

1. Verfahren zur Erzeugung von Oberflächenstrukturen auf elektrisch leitenden oder halbleitenden Substratoberflächen im Bereich atomarer Dimensionen mit einem Rastertunnelmikroskop, wobei mittels eines Tunnelstroms das Substrat lokal erwärmt wird und somit thermische Umwandlungen eingeleitet werden, dadurch gekennzeichnet, dass die Tunnelspitze (2) im normalen Tunnelbetrieb an ausgewählte Positionen über dem Substrat (1) gefahren wird, an welchem die Struktur entstehen soll, dass dann der Abstand zwischen der Tunnelspitze (2) und dem Substrat (1) vergrössert und gleichzeitig die Tunnelspannung derart erhöht wird, dass der Tunnelstrom ($I_T$) konstant bleibt, und dass anschliessend die Tunnelspitze (2) bei konstant gehaltener Tunnelspannung so weit dem Substrat (1) angenähert wird, dass ein vorgegebener Tunnelstrom ($I_T$) zwischen der Tunnelspitze (2) und dem Substrat (1) fliesst.

2. Verfahren nach Anspruch 1, dadurch gekennzeichnet, dass die Substratoberfläche an den ausgewählten Positionen durch Anwendung des Tunneleffekts geschmolzen und anschliessend so rasch wieder abgekühlt wird, dass sich amorphe Strukturen bilden oder erhalten.

3. Verfahren nach Anspruch 1, dadurch gekennzeichnet, dass die Substratoberfläche an den ausgewählten Positionen durch Anwendung des Tunneleffekts geschmolzen und so langsam abgekühlt wird, dass sich kristalline Strukturen bilden oder erhalten bleiben.

4. Verfahren nach Anspruch 1, dadurch gekennzeichnet, dass die Substratoberfläche an den ausgewählten Positionen durch Anwendung des Tunneleffekts geschmolzen und im geschmolzenen Zustand elektrischen Feldern ausgesetzt wird, wodurch die Substratoberfläche an diesen Positionen durch Auftreten elektrostatischer Effekte von der Tunnelspitze angezogen wird, und dass die verformte Substratoberfläche daraufhin zum Erstarren gebracht wird.

5. Verfahren nach Anspruch 1, angewendet auf eine Legierung, dadurch gekennzeichnet, dass die Substratoberfläche an den ausgewählten Positionen durch Anwendung des Tunneleffekts geschmolzen wird und im geschmolzenen Zustand mindestens eine Legierungskomponente zum Segregieren oder Migrieren an die Oberfläche veranlasst wird.

6. Verfahren nach Anspruch 4, dadurch gekennzeichnet, dass die Behandlung auf Strukturen angewendet wird, die auf der Substratoberfläche bereits vorhanden sind, wodurch diese ganz oder teilweise überschrieben werden.

7. Verfahren nach Anspruch 4, dadurch gekennzeichnet, dass die Tunnelspitze, die einen niedrigeren Schmelzpunkt aufweist als das zu behandelnde Substrat, an ihrer der Substratoberfläche zugewandten äussersten Spitze durch Anwendung des Tunneleffekts zum Schmelzen gebracht wird und dass unter dem Einfluss des elektrischen Feldes geschmolzenes Tunnelspitzen-Material auf der Substratoberfläche deponiert wird.

8. Verfahren nach Anspruch 7, dadurch gekennzeichnet, dass die Tunnelspitze ferromagnetisches Material enthält.

9. Vorrichtung mit einem Rastertunnelmikroskop und einer Tunnelspitze zur Erzeugung von Oberflächenstrukturen nach dem Verfahren gemäss Anspruch 1, dadurch gekennzeichnet, dass die Vorrichtung mit einer steuerbaren Positioniervorrichtung (40, 41, 42, 46) zum gegenseitigen Annähern zwischen Substratoberfläche (1) und der Tunnelspitze (2) bis auf Nanometerdistanz ausgestatet ist, dass die Positioniervorrichtung mit einem vom Tunnelstrom ($I_T$) beeinflussten Regelsystem (62, 64) zur Nachführung der Tunnelspitze (2) in Verbindung steht und dass eine Messsignaleinrichtung (62) zum Ableiten eines Messsignals (M) aus dem Nachführsignal für die Tunnelspitze (2) an einen Rechner (60) zur Zuordnung der Messwerte zu entsprechenden Abtastpositionen angeschlossen ist.

10. Vorrichtung nach Anspruch 9, dadurch gekennzeichnet, dass impulsgesteuert angetriebene Bewegungselemente (40, 41 ; 43, 44) über mechanische Koppelglieder (42, 53) mit dem Substrathalter (48) in Verbindung stehen.

11. Vorrichtung nach Anspruch 10, dadurch gekennzeichnet, dass die mechanischen Koppelglieder (42, 53) mit Mitteln zur Weguntersetzung versehen sind.

12. Vorrichtung nach Anspruch 9, dadurch gekennzeichnet, dass zur Erreichung einer gesteuerten Relativbewegung berüglich der Höhendistanz zwischen den am Tunneleffekt beteiligten Elementen (49, 2) eine um eine horizontale Achse (B) gelagerte Klappe vorgesehen ist, welche eines der am Tunneleffekt beteiligten Elemente (49) aufnimmt, und dass zur Verstellung der Klappe relativ zum zweiten am Tunneleffekt beteiligten Element (2) ein gesteuert verschiebbarer und an der Klappe angreifender Keil (42) vorgesehen ist.

13. Vorrichtung nach Anspruch 12, dadurch gekennzeichnet, dass der Keil (42) mit einem Permanentmagneten (41) verbunden ist, der in eine Spule (40) ragt und durch Stromimpulse bewegbar ist.

14. Vorrichtung nach Anspruch 12, dadurch gekennzeichnet, dass auf der Klappe eine Bewegungsvorrichtung für eine zweidimensionale horizontale Bewegung eines der am Tunneleffekt beteiligten Elemente angebracht ist.

15. Vorrichtung nach Anspruch 12, dadurch gekennzeichnet, dass auf der Klappe ein Substrathalter (48) angebracht ist.

16. Vorrichtung nach Anspruch 15, dadurch gekennzeichnet, dass die Tunnelspitze (2) an einem um eine Achse (A) vom Substrathalter (48) wegklappbaren Rasterkopt (45, 46, 47) angebracht ist.

17. Vorrichtung nach Anspruch 16, dadurch gekennzeichnet, dass der Rasterkopf (45, 46, 47) auswechselbar ist.

18. Vorrichtung nach Anspruch 9, dadurch gekennzeichnet, dass die Tunnelspitze (2) aus einem ferromagnetischen Material besteht.

## Claims

1. A process for producing surface structures in the atomic dimensions range on electrically conductive or

EP 0 292 519 B1

semiconductive substrate surfaces by means of a scanning tunnel microscope, the substrate being heated locally by means of a tunnel current and consequently thermal changes being initiated, characterized in that in normal tunnel operation the tunnel tip (2) is conveyed to selected positions across the substrate (1) at which the structure is to be produced, in that then the distance between the tunnel tip (2) and the substrate (1) is increased and at the same time the tunnel voltage is raised in such a manner that the tunnel current ($I_T$) remains constant, and in that subsequently with the tunnel voltage kept constant the tunnel tip (2) is brought closer to the substrate (1) to the extent that a predetermined tunnel current ($I_T$) flows between the tunnel tip (2) and the substrate (1).

2. A process in accordance with Claim 1, characterized in that the substrate surface is melted at the selected positions through the use of the tunnel effect and is subsequently cooled down again so quickly that amorphous structures form or are kept.

3. A process in accordance with Claim 1, characterized in that the substrate surface is melted at the selected positions through the use of the tunnel effect and is cooled down so slowly that crystalline structures form or remain in existence.

4. A process in accordance with Claim 1, characterized in that the substrate surface is melted at the selected positions through the use of the tunnel effect and in this melted state is exposed to electric fields, whereby at these positions the substrate surface is attracted by the tunnel tip due to the occurrence of electrostatic effects, and in that the shaped substrate surface is thereupon caused to solidify.

5. A process in accordance with Claim 1, used on an alloy, characterized in that the substrate surface is melted at the selected positions through the use of the tunnel effect and in the melted state at least one alloy constituent is caused to segregate or migrate to the surface.

6. A process in accordance with Claim 4, characterized in that the treatment is used on structures already present on the substrate surface, whereby these structures are totally or partially overwritten.

7. A process in accordance with Claim 4, characterized in that the tunnel tip, which has a lower melting point than the substrate to be treated, is caused to melt at its outermost tip turned towards the substrate surface through the use of the tunnel effect, and in that tunnel-tip material melted under the influence of the electric field is deposited on the substrate surface.

8. A process in accordance with Claim 7, characterized in that the tunnel tip contains ferromagnetic material.

9. A device which has a scanning tunnel microscope and a tunnel tip and is for producing surface structures in accordance with the process according to Claim 1, characterized in that the device is equipped with a controllable positioning device (40, 41, 42, 46) for drawing both the substrate surface (1) and the tunnel tip (2) closer to one another to a distance in the nanometer range, in that the positioning device is connected to a regulating system (62, 64) which is influenced by the tunnel current ($I_T$) and is for tracking the tunnel tip (2), and in that a measurement signal device (62) for deriving a measurement signal (M) from the tracking signal for the tunnel tip (2) is connected up to a computer (60) for allocation of the measured values to appropriate scanning positions.

10. A device in accordance with Claim 9, characterized in that motive elements (40, 41 ; 43, 44) driven in a pulse-controlled manner are connected to the substrate holder (48) via mechanical coupling elements (42, 53).

11. A device in accordance with Claim 10, characterized in that the mechanical coupling elements (42, 53) are provided with means for path reduction.

12. A device in accordance with Claim 9, characterized in that in order to achieve a controlled relative movement with regard to the vertical distance between the elements (49, 2) active in the tunnel effect there is provided a flap which is mounted about a horizontal axis (B) and receives one of the elements (49) active in the tunnel effect, and in that to shift the flap in relation to the second element (2) active in the tunnel effect there is provided a wedge (42) which acts on the flap and is moveable in a controlled manner.

13. A device in accordance with Claim 12, characterized in that the wedge (42) is connected to a permanent magnet (41) which protrudes into a coil (40) and is moveable by means of current pulses.

14. A device in accordance with Claim 12, characterized in that a motive device for two-dimensional horizontal movement of one of the elements active in the tunnel effect is fixed on the flap.

15. A device in accordance with Claim 12, characterized in that a substrate holder (48) is fixed on the flap.

16. A device in accordance with Claim 15, characterized in that the tunnel tip (2) is fixed to a screen head (45, 46, 47) foldable away from the substrate holder (48) about an axis (A).

17. A device in accordance with Claim 16, characterized in that the scanning head (45, 46, 47) is exchangeable.

18. A device in accordance with Claim 9, characterized in that the tunnel tip (2) is composed of a ferromagnetic material.

7

**Revendications**

1. Procédé pour produire des structures de surface sur des surfaces de substrats électriquement conducteurs ou semi-conducteurs dans la plage des dimensions atomiques, à l'aide d'un microscope tunnel à balayage, selon lequel le substrat est localement chauffé au moyen d'un courant tunnel, ce qui déclenche des transformations thermiques, caractérisé en ce que la pointe de tunnel (2), en fonctionnement tunnel normal, est amenée dans des positions sélectionnées au-dessus du substrat (1) sur lequel doit se former la structure, en ce qu'on augmente alors la distance entre la pointe de tunnel (2) et le substrat (1) et qu'en même temps on augmente la tension tunnel de telle sorte que le courant tunnel ($I_T$) reste constant, et en ce qu'ensuite, tout en maintenant constante la tension tunnel, on approche la pointe de tunnel (2) du substrat (1) jusqu'à ce qu'un courant tunnel ($I_T$) prédéterminé s'écoule entre la pointe de tunnel (2) et le substrat (1).

2. Procédé selon la revendication 1, caractérisé en ce qu'aux positions sélectionnées, la surface du substrat fond par l'utilisation de l'effet tunnel et qu'on la refroidit ensuite suffisamment vite pour que des structures amorphes se forment ou soient maintenues.

3. Procédé selon la revendication 1, caractérisé en ce qu'aux positions sélectionnées, la surface du substrat fond par l'utilisation de l'effet tunnel et qu'on la refroidit ensuite suffisamment lentement pour que des structures cristallines se forment ou soient maintenues.

4. Procédé selon la revendication 1, caractérisé en ce que la surface du substrat est fondue aux positions sélectionnées par l'utilisation de l'effet tunnel, qu'elle est soumise à l'état fondu à des champs électriques, grâce à quoi, à ces positions, la surface du substrat est attirée par la pointe de tunnel du fait de l'apparition d'effets électrostatiques, et en ce qu'on fait ensuite se solidifier la surface déformée du substrat.

5. Procédé selon la revendication 1, utilisé sur un alliage, caractérisé en ce qu'aux positions sélectionnées, la surface du substrat est fondue par l'utilisation de l'effet tunnel et qu'à l'état fondu, au moins un composant de l'alliage est amené à se séparer ou à migrer à la surface.

6. Procédé selon la revendication 4, caractérisé en ce qu'on utilise le traitement sur des structures existant déjà sur la surface du substrat, d'où il résulte que celle-ci est totalement ou partiellement recouverte.

7. Procédé selon la revendication 4, caractérisé en ce que la pointe de tunnel, qui a un point de fusion plus bas que le substrat à traiter, est amenée à fondre sur sa pointe la plus extérieure tournée vers la surface du substrat, par l'utilisation de l'effet tunnel, et en ce que la matière de la pointe de tunnel fondue sous l'action du champ électrique est déposée sur la surface du substrat.

8. Procédé selon la revendication 7, caractérisé en ce que la pointe de tunnel contient un matériau ferromagnétique.

9. Dispositif comportant un microscope tunnel à balayage et une pointe de tunnel pour produire des structures de surface selon le procédé de la revendication 1, caractérisé en ce que le dispositif est équipé d'un dispositif de positionnement commandé (40, 41, 42, 46) pour approcher l'une de l'autre la surface du substrat (1) et la pointe de tunnel (2) jusqu'à une distance nanométrique, en ce que le dispositif de positionnement est relié à un système de réglage (62, 64) soumis au courant tunnel ($I_T$) pour faire suivre la pointe de tunnel (2) et en ce qu'un dispositif de signaux de mesure (62) pour dériver un signal de mesure (M) à partir du signal de poursuite pour la pointe de tunnel (2) est raccordé à un ordinateur (60) pour affecter les valeurs mesurées aux positions d'exploration correspondantes.

10. Dispositif selon la revendication 9, caractérisé en ce que des éléments de déplacement (40, 41 ; 43, 44) commandés par impulsions sont reliés par des éléments d'accouplement mécaniques (42, 53) au support de substrat (48).

11. Dispositif selon la revendication 10, caractérisé en ce que les éléments d'accouplement mécaniques (42, 53) sont munis de moyens pour démultiplier la course.

12. Dispositif selon la revendication 9, caractérisé en ce qu'on prévoit, pour obtenir un mouvement relatif commandé par rapport à la distance en hauteur entre les éléments (49, 2) participant à l'effet tunnel, un volet monté autour d'un axe horizontal (B), qui reçoit l'un des éléments (49) participant à l'effet tunnel, et en ce qu'on prévoit, pour déplacer le volet par rapport au deuxième élément (2) participant à l'effet tunnel, un coin (42) déplaçable par commande et agissant sur le volet.

13. Dispositif selon la revendication 12, caractérisé en ce que le coin (42) est relié à un aimant permanent (41) qui saille dans une bobine (40) et peut être mû par des impulsions de courant.

14. Dispositif selon la revendication 12, caractérisé en ce qu'on place sur le volet un dispositif de déplacement pour le déplacement horizontal bidimensionnel d'un des éléments participant à l'effet tunnel.

15. Dispositif selon la revendication 12, caractérisé en ce qu'on place sur le volet un support de substrat (48).

16. Dispositif selon la revendication 15, caractérisé en ce que la pointe de tunnel (2) est placée sur une tête de balayage (45, 46, 47) pouvant être rabattue autour d'un axe (A) pour l'éloigner du support de substrat (48).

17. Dispositif selon la revendication 16, caractérisé en ce que la tête de balayage (45, 46, 47) est interchangeable.

18. Dispositif selon la revendication 9, caractérisé en ce que la pointe de tunnel (2) est en un matériau ferromagnétique.

Fig. 1

Fig. 2

Fig. 3

EP 0 292 519 B1

Fig. 4

Fig. 5

Fig. 6

Fig. 7

EP 0 292 519 B1

Fig. 8

Fig. 9